Europäisches Patentamt

European Patent Office

Office européen des brevets

(11) Publication number: **0 150 214**
**B1**

(12)    EUROPEAN PATENT SPECIFICATION

(45) Date of publication of patent specification: **13.09.89**

(51) Int. Cl.⁴: **H 01 S 3/082,** H 01 S 3/19

(21) Application number: **84903303.0**

(22) Date of filing: **11.06.84**

(86) International application number:
**PCT/US84/00884**

(87) International publication number:
**WO 85/00702 14.02.85 Gazette 85/04**

(54) **COUPLED CAVITY LASER.**

(30) Priority: **28.07.83 US 518127**

(43) Date of publication of application:
**07.08.85 Bulletin 85/32**

(45) Publication of the grant of the patent:
**13.09.89 Bulletin 89/37**

(84) Designated Contracting States:
**BE DE FR GB NL**

(56) References cited:
**JP-A-55 048 993**
**US-A-3 803 511**
**US-A-4 079 339**
**US-A-4 101 845**

**OPTICS COMMUNICATIONS, vol. 31, no. 1,**
**October 1979, pages 81-84, Amsterdam, NL; T.**
**KANADA et al.: "Single-mode operation of a**
**modulated laser diode with a short external**
**cavity"**

(73) Proprietor: **AMERICAN TELEPHONE AND**
**TELEGRAPH COMPANY**
**550 Madison Avenue**
**New York, NY 10022 (US)**

(72) Inventor: **LIOU, Kang**
**336 Bogie Avenue**
**Wescoesville, PA 18106 (US)**

(74) Representative: **Watts, Christopher Malcolm**
**Kelway et al**
**AT&T (UK) LTD. AT&T Intellectual Property**
**Division 5 Mornington Road**
**Woodford Green Essex IG8 OTU (GB)**

(56) References cited:
**ELECTRONICS LETTERS, vol. 17, no. 15, 23rd**
**July 1981, pages 527-529, London, GB; S.**
**AKIBA et al.: "High rate pulse generation from**
**InGaAsP laser in selfoc lens external resonator"**

**ELECTRONICS LETTERS, vol. 19, no. 14, 7th**
**July 1983, pages 552-553, London, GB; R.S.**
**TUCKER et al.: "10GHz active mode-locking of**
**a 1.3mum ridge-waveguide laser in an optical-**
**fibre cavity"**

Courier Press, Leamington Spa, England.

(56) References cited:

J.Appl.Phys. 51(6), issued Jan. 1980, Figueroa
et al. "Studies of (GaAl) As injection lasers
operating with an optical fiber resonator", pp.
3062-71

Appl. Phys. Lett. 42(1), issued 01. Jan. 1983,
Ebeling et al. "Single-mode operation of
coupled-cavity GaInAsP/InP semiconductor
lasers", pp. 6-8

Post Deadline Paper No. PD5-1, Topical
meeting on optical fiber communication, New
Orleans, Feb. 28 - March 2, 1983, Lin et al.

## Description

Background of the invention

Single frequency laser sources are of great interest for high bandwidth single-mode fiber communication systems.

Longitudinal mode selection by a coupled cavity arrangement comprising a laser cavity optical source optically coupled to a second optical cavity has been investigated as an approach to achieve single-longitudinal-mode (single frequency) operation of semiconductor lasers. (See D. A. Kleinman and P. P. Kisliuk, The Bell System Technical Journal, *Volume 41*, p. 453, March, 1962 and P. W. Smith, Proceedings of the IEEE, *Volume 60*, No. 4, p. 422, April, 1972). In such coupled cavity devices, light from a multi-longitudinal mode laser is coupled to the second cavity and reflected back to the laser cavity. By proper selection of the relative dimensions of the two cavities, a resonant condition is obtained in which a desired single frequency output is obtained. In effect, unwanted longitudinal modes are suppressed in favor of the desired mode.

The second cavity optically coupled to the laser can be either a passive cavity comprising a light reflector spaced, in air, from the laser, or a second laser cavity with bias-current control. (D. Renner and J. E. Carroll, Electronics Letters, *Volume 15*, No. 3, p. 73, February 1979; C. Lin and C. A. Burrus, Post Deadline Paper No. PD5-1, Topical Meeting on Optical Fiber Communication, New Orleans, February 28—March 2, 1983; L. A. Coldren, B. I. Miller, K. Iga, and J. A. Rentschler, Applied Physics Letters, *Volume 38*, p. 315, March, 1981; and K. J. Ebeling, L. A. Coldren, B. I. Miller, and J. A. Rentschler, Applied Physics Letters, *Volume 42*, p. 6, January, 1983). A long laser cavity and a shorter second passive, or active, cavity are used in such a coupled cavity geometry. The passive-active coupled cavity arrangement is attractive for its simplicity, because, for example, the second cavity can be readily combined with known and commercially available lasers.

In such combination, a concave spherical mirror has been used to reflect the laser light, in a narrow beam to reduce losses, back to the laser. (See K. R. Preston, K. C. Woolard, and K. H. Cameron, Electronics Letters, *Volume 17*, No. 24, p. 931, November, 1981). However, manufacturing and alignment of the spherical mirror is difficult. A coupled planar Au mirror can be used to provide a short passive cavity. A longer passive cavity cannot be provided with a flat mirror because of the poor optical coupling efficiency between the two cavities caused by light beam dispersion.

Statement of the invention

An optimized coupling efficiency between the active laser and the passive cavity is required for reliable single-mode operation. This is achieved according to the invention as claimed in Claim 1 by coupling to the laser a passive graded index lens stabilizer cavity. The passive cavity is terminated with a highly reflective surface. The passive cavity may be attached to or be in close proximity to the laser. The passive cavity has an optical length that is less than the corresponding optical length of the active laser cavity. This ensures stable suppression of unwanted longitudinal modes. Preferably, the coupled graded index cavity has a length slightly less than a quarter pitch of the light path such that the reflected light is focused at the front face of the laser.

Description of the drawing

Fig. 1 is a schematic representation of the passive-to-active coupled cavity laser of the invention;

Fig. 2 is a diagram of a first embodiment of the invention;

Fig. 3 is a diagram of another embodiment of the invention;

Fig. 4 is a diagram showing continuous wave and square wave pulsed spectra for the laser alone (a) and for the coupled cavity arrangement of the invention (b).

Detailed description

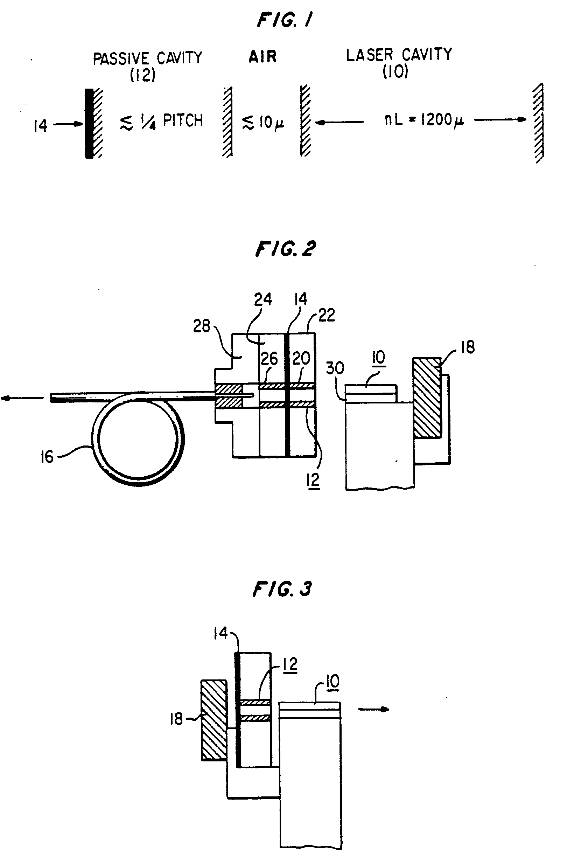

The basic arrangement of the inventive coupled cavity laser is shown in Fig. 1. An active laser cavity 10 is shown in close proximity to a passive graded index (GRIN) cavity 12. An air space of 10 μm is shown between the active and passive cavities. Alternatively, the two cavities may be butted, or even joined together with epoxy or the like. If separated as shown it is preferred that they be close, e.g. within 50 μ, and preferably within 10 μ, to maximize coupling. The front end of the graded index cavity facing the laser can be antireflection coated in case reflection from that surface affects mode stability.

The passive graded index cavity is bounded (on its left, as viewed in Fig. 1) by a totally or partially reflecting mirror 14. The reflectivity of the mirror depends on the amount, if any, of radiation desired from that end of the coupled cavity assembly. The coupled cavity device can be designed for output coupled to a transmission fiber 16 through the mirror as shown in Fig. 2, in which case the mirror is designed to pass the desired amount of light. Also, the device can be designed with a power (or even a spectral) monitor 18 at the other facet of the active cavity as shown. Fig. 3 shows an alternative arrangement with the output radiation taken from the active cavity of the device. The monitor is optically coupled to the partially transmission mirror. In each instance, the axes of the two cavities are in alignment.

Further details of the device are as follows.

GRIN cavities with a short length compared to the laser cavity length were prepared from graded index multimode fiber. The fiber 20 was bonded inside a glass capillary tube 22 (Fig. 2), and was polished from both ends to a predetermined length. One end was then coated with a layer 14 comprising Cr and Au for high relectivity. The coated end was then bonded to another capillary tube 24 having a multimode fiber 26 disposed therewithin. This latter tube-fiber member 24—26 does not affect the operation of the coupled cavity laser which "ends" at the CrAu layer. The member 24—26 serves, however, as a convenient means for handling the GRIN cavity and for coupling it to a conventional light fiber coupler 28. The member 24—26 can be omitted. The mode spacing of an InGaAsP BH laser 10 is 0.7nm (7Å), from which the effective cavity length in air is 1200 µm. The air gap between the GRIN cavity 12 and the laser facet 30 was ≤10 µm. This air spaced cavity did not contribute to the mode selection effect due to its large cavity mode spacing (≳120× laser mode spacing).

The graded index fiber 20 used for the GRIN cavity had a 0.29 numerical aperture and 70 µm core diameter. The length of the GRIN cavity 12 was 170 µm which was made shorter than a quarter pitch to have a focal point in air. This results in nearly a 4:1 ratio of the external cavity mode spacing to the laser mode spacing. A ratio chosen between 3:1 and 6:1 would be appropriate. By employing the coupled cavity approach described here it is also appropriate to use shorter active laser cavities than one might otherwise find expedient from the standpoint of laser lifetime.

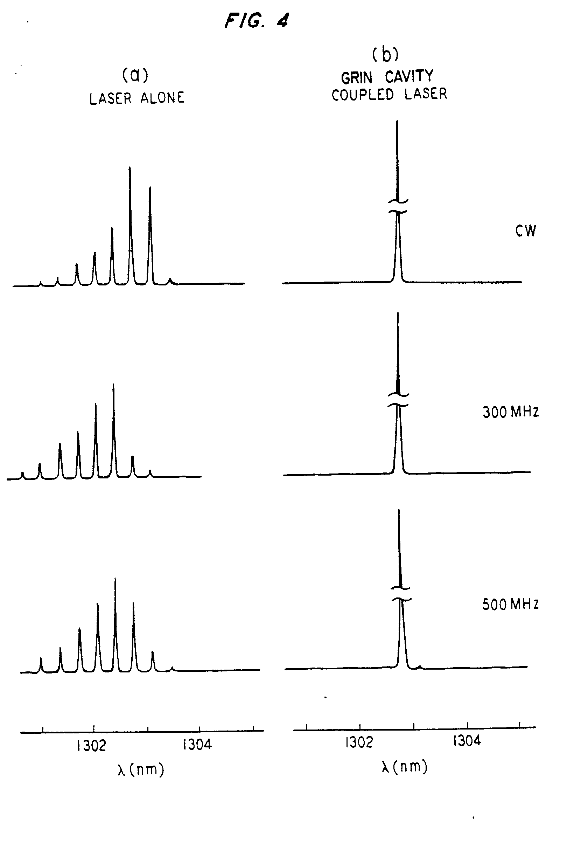

The 6mW/facet continuous wave spectrum for the InGaAsP BH laser biased at 51mA ($I_{th}$=23mA) at 23 degrees C is shown in Fig. 4a. A maximum of 40% increase in light output was observed when the GRIN cavity was coupled to the laser. The corresponding 6mW continuous wave single-longitudinal-mode spectrum at the same heat sink temperature is shown in Fig. 4b. The laser with the coupled external cavity was pulsed by a square wave generator from threshold to 6mW. A beam splitter was used for simultaneous measurements of the spectrum and the ligth output pulses detected with a high speed InGaAs/InP PIN photodiode. (See T. P. Lee, C. A. Burrus, K. Ogawa, and A. G. Dentai, Electronics Letters, *Volume 17*, No. 12, p. 431, 1981). The on/off extinction ratio was better than 30:1. The spectra of the GRIN external cavity laser under 300 MHz and 500 MHz square wave modulation are also shown in Fig. 4b. The corresponding multimoded spectra for the laser alone are shown in Fig. 4a. The same longitudinal mode was stabilized with the external cavity as the modulation rate was varied. The most significant side mode intensity relative to the main mode intensity was suppressed by 23dB and 20dB respectively at 300 MHz and 500 MHz. Under continuous wave operation the side mode suppression ratio was better than 25dB. When the laser was pulsed from above $I_{th}$, the amplitude of the first relaxation oscillation peak decreased and the mode suppression ratio approached that under continous wave operation with the penalty of a decreased on/off light output extinction ratio.

## Claims

1. A cavity coupled laser device comprising a semiconductor laser cavity (10) and a passive optical cavity (12) coupled thereto for single-mode operation of the laser cavity, said passive optical cavity comprising a graded index lens (12) with its axis aligned to the output axis of the laser cavity, and a reflecting coating (14) on a surface of the graded index lens so that light emerging from the laser cavity traverses an optical path through the graded index lens and onto said reflective coating, the length of the optical path through the passive cavity being less than the length of the optical path in the laser cavity.

2. The device of claim 1 in which the graded index lens is a length of glass fiber waveguide (20).

3. The device of claim 1 in which the length of the optical path one way through the passive cavity is slightly less than 1/4 pitch.

## Patentansprüche

1. Resonator-gekoppelte Laservorrichtung, umfassend einen Halbleiter-Laserresonator (10) und einen hieren gekoppelten passiven optischen Resonator (12) für einen Einzelmodenbetrieb des Laserresonators, wobei der passive optische Resonator eine Brechungsindexgradienten-Linse (12), deren Aches mit der Ausgangsachse des Laserresonators ausgerichtet ist, und einen reflektierenden Belag (14) auf einer Fläche der Brechungsindexgradienten-Linse umfaßt, so daß aus dem Laserresonator austretendes Licht einen optischen Weg durch die Brechungsindexgradientenlinse und auf den reflektierenden Belag durchquert, wobei die optische Weglänge durch den passiven Resonator kleiner als die optische Weglänge im Laserresonator ist.

2. Vorrichtung nach Anspruch 1, bei der die Brechungsindexgradientenlinse ein Stück eines Glasfaserwellenleiters (20) ist.

3. Vorrichtung nach Anspruch 1, bei der die einfache optische Weglänge durch den passiven Resonator wenig kleiner als 1/4 Teilung ist.

## Revendications

1. Un dispositif laser à cavités couplées comprenant une cavité laser à semiconducteurs (10) et une cavité optique passive (12) qui lui est couplée, pour faire fonctionner la cavité laser en régime monomode, cette cavité optique passive comprenant une lentille à gradient d'indice (12) dont l'axe est aligné sur l'axe de sortie de la cavité laser, et un revêtement réfléchissant (14) sur une surface de la lentille à gradient d'indice, de façon que la lumière qui émerge de la cavité laser parcoure un chemin optique qui traverse la lentille à gradient d'indice et arrive sur le revêtement réfléchissant, la longueur du chemin optique dans la cavité passive étant inférieure à la longueur du chemin optique dans la cavité laser.

2. Le dispositif de la revendication 1, dans lequel la lentille à gradient d'indice est formée par une longueur de guide d'ondes à fibre de verre (20).

3. Le dispositif de la revendication 1, dans lequel la longueur du chemin optique unidirectionnel dans la cavité passive est légèrement inférieure à un quart du pas.

EP 0 150 214 B1

## FIG. 1

PASSIVE CAVITY (12)　　AIR　　LASER CAVITY (10)

14 →　≲ ¼ PITCH　≲ 10µ　← nL = 1200µ →

## FIG. 2

28　24　14　22
26　20　18
16　30　10
12

## FIG. 3

14　12　10
18

1

## FIG. 4

(a)
LASER ALONE

(b)
GRIN CAVITY
COUPLED LASER

CW

300 MHz

500 MHz

1302          1304
λ (nm)

1302          1304
λ (nm)